Europäisches Patentamt

European Patent Office

Office européen des brevets

(19)

(11) Veröffentlichungsnummer: **0 171 051**
**A1**

(12) # EUROPÄISCHE PATENTANMELDUNG

(21) Anmeldenummer: 85109825.1

(22) Anmeldetag: 05.08.85

(51) Int. Cl.⁴: **H 01 L 23/46,** H 01 L 23/42, H 01 L 25/16

(30) Priorität: 08.08.84 DE 3429281

(43) Veröffentlichungstag der Anmeldung: **12.02.86**
**Patentblatt 86/7**

(84) Benannte Vertragsstaaten: **AT BE CH DE FR GB IT LI LU NL SE**

(71) Anmelder: **Siemens Aktiengesellschaft, Berlin und München Wittelsbacherplatz 2, D-8000 München 2 (DE)**

(72) Erfinder: **Prussas, Herbert, Dipl.-Ing., Mozartring 11, D-8069 Reichertshausen (DE)**

(54) Gehäuse für einen im Betrieb Verlustwärme abgebenden Halbleiterkörper.

(57) Gehäuse für einen im Betrieb Verlustwärme abgebenden Halbleiterkörper (IC), wobei Gehäuseoberflächen (W, G) im Betrieb durch ein fliessfähiges Kühlmedium (KL) gekühlt werden, und wobei der Wärmewiderstand zwischen dem Halbleiterkörper (IC) und der wärmeleitend mit ihm verbundenen Kühlfläche der Gehäuseoberfläche niedrig ist.

Ein Freiraum zwischen dem Halbleiterkörper (IC) und der Gehäusewand (G, W) enthält mindestens ein sich einerseits zwischen den Halbleiterkörper (IC) und andererseits die Gehäusewand (G, W) stemmendes wärmeleitendes Federelement.

SIEMENS AKTIENGESELLSCHAFT

Berlin und München

Unser Zeichen:

VPA    84 P 1 5 8 4 E

Gehäuse für einen im Betrieb Verlustwärme abgebenden Halbleiterkörper.

Die Erfindung stellt eine Verbesserung des im Oberbegriff des Patentanspruches 1 angegebenen speziellen Gehäuses dar, das für sich dem Fachmann wohlbekannt ist. Der niedrige Wärmewiderstand wird im wesentlichen dort durch enge, möglichst großflächige Berührung zwischen dem Halbleiterkörper und einem Bereiche der Gehäusewand, oder zwischen dem Halbleiterkörper und einem die Gehäusewand berührenden wärmeleitenden Sockel erreicht.

Die Erfindung wurde für ein 200 mBit-Lichtsendemodulgehäuse mit einem Treiber als Halbleiterkörper entwickelt, wobei die hohe Verlustwärme, z.B. 1W des im Betrieb z.B. 125 °C heißen Treibers, möglichst schnell an das dem Gehäuse zuströmende Kühlmedium von z.B. 40 °C Anfangstemperatur und 100 m/min Geschwindigkeit abzugeben ist (dort sind übrigens noch weitere Halbleiterkörper im selben Gehäuse mituntergebracht). Ohne ganz besondere zusätzliche Kühlmaßnahmen wird der Halbleiterkörper/Treiber zu heiß und ist dann nicht mehr betriebssicher. Die Erfindung eignet sich aber schlechthin auch für ein Gehäuse mit nur einem einzigen, an sich beliebigen, gut zu kühlenden Halbleiterkörper.

Die Aufgabe der Erfindung ist, die Wärmeableitung vom Halbleiterkörper zur zu kühlenden Kühlfläche, die an der Oberfläche des Gehäuses ist, weiter zu erhöhen, was durch die im Patentanspruch 1 genannten Maßnahmen gelöst wird.

Be 1 Ky/03.08.84

Die in den Unteransprüchen genannten Maßnahmen gestatten, zusätzliche Vorteile zu erreichen, nämlich die Maßnahmen gemäß Patentanspruch

2, die Federelemente leicht herstellen und in das Gehäuse einbauen zu können, und trotzdem auch bei sehr großen Toleranzen der Maße der Federelemente und aller Maße der sonstigen Teile des Gehäuses, zuverlässig viele, unter erhöhtem Druck gebildete, jeweils gut wärmeleitende Wärmeübergangsstellen zur Gehäusewand hin zu bieten,

3, die Wärme rasch vom Halbleiterkörper über eine Abdeckung breitflächig auf die Federelemente verteilen und den Halbleiterkörper vor Beschädigungen beim Einbau der Federelemente schützen zu können,

4, den Einbau der Federelemente zu erleichtern, insbesondere die Gefahr eines Verrutschens vom Halbleiterkörper oder vom Federelement bzw. von Teilen des Federelementes verringern zu können, sowie

5, einen mechanischen Druck zu begrenzen/vermeiden.

Die Erfindung und ihre Weiterbildungen werden anhand der in den Figuren gezeigten Beispiele der Erfindung weiter erläutert, wobei die Figur

1 einen speziellen, ebenfalls in einer prioritätsgleichen Anmeldung erfaßten Aufbau eines Gehäuses für ein an eine Glasfaser anzuschließendes Lichtsendemodul, wobei ein als Treiber dienender Halbleiterkörper seine Verlustwärme über eine Abdeckung und Federelemente an die Gehäusewand abgibt,

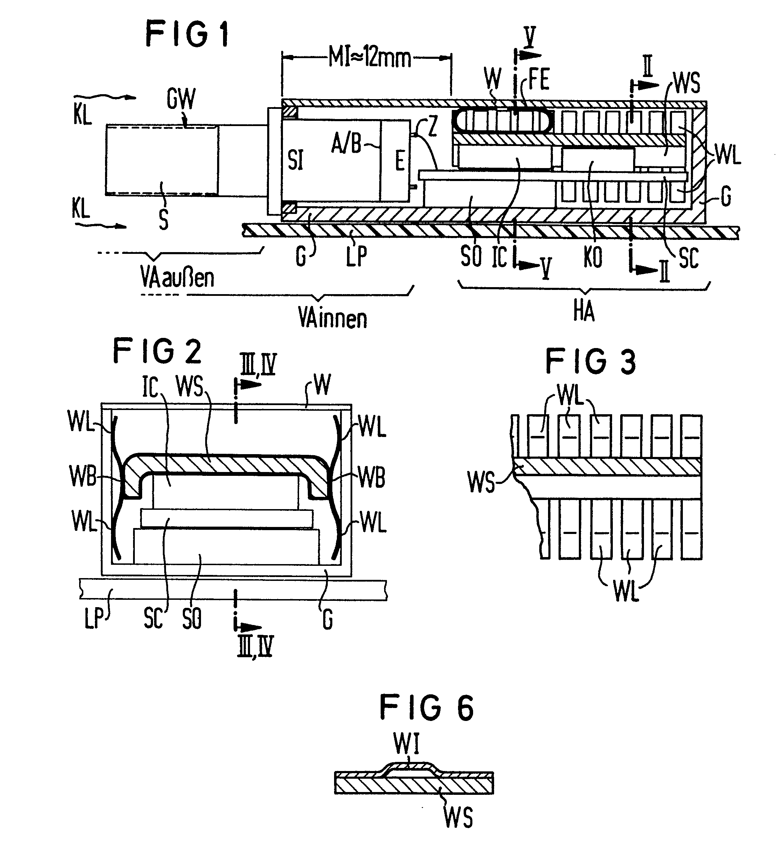

2 einen Schnitt, vgl. Fig. 1,

3 einen Schnitt, vgl. Fig. 2,

4 Federelemente und Abdeckung vor dem Einbau ins Gehäuse,

5 einen Schnitt, vgl. Fig. 1,

6 eine Variante der Abdeckung und

7 ein Beispiel für den Einbau solcher Gehäuse unter räumlich äußerst beengten Verhältnissen und unter entsprechend erschwerter Zufuhr von Kühlmedium zeigen.

Das in Fig. 1 gezeigte, zwei zu kühlende Halbleiterkörper enthaltende gemeinsame spezielle Gehäuse ist also bereits in einer prioritätsgleichen Anmeldung, nämlich P .. .. ... = 84 P **1583 DE** im Detail beschrieben. Hier werden - wegen der Überlappung der Weiterbildungen des Gegenstandes der prioritätsgleichen Anmeldung und des Gegenstandes der vorliegenden Schrift - nur einige dieser Details von Fig. 1 zur Unterstützung der Beschreibung der Aufgabe und Lösung der Erfindung beschrieben:

Das in Fig. 1 gezeigte gemeinsame Gehäuse enthält einen vorderen und einen hinteren Abschnitt VA, HA für die zwei räumlich getrennten, im Gehäuseinneren angebrachten Halbleiterkörper D, IC, wobei die, z.B. ganz aus Metall bestehende, Gehäuseoberfläche W, G im Betrieb durch ein fließfähiges Kühlmedium KL, bevorzugt Kühlluft KL, gekühlt wird. Die maximale Betriebstemperatur des hinteren Halbleiterkörpers IC ist zumindest zeitweise höher als die maximale Betriebstemperatur des vorderen Halbleiterkörpers D. Der Wärmewiderstand zwischen dem vorderen Halbleiterkörper D und einer wärmeleitend mit ihm verbundenen vorderen Kühlfläche GW/S, VA außen der Gehäuseoberfläche am vorderen Abschnitt VA, sowie der Wärmewiderstand zwischen dem hinteren Halbleiterkörper IC und einer wärmeleitend mit ihm verbundenen hinteren, von der vorderen verschiedenen, Kühlfläche der Gehäuseoberfläche am hinteren Abschnitt HA ist jeweils niedriger als sowohl der Wärmewiderstand im Gehäuseinneren zwischen den beiden Halbleiterkörpern D, IC als auch der Wärmewiderstand zwischen der vorderen und der hinteren Kühlfläche. Im Betrieb fließt das Kühlmedium KL zuerst vorbei an der vorderen Kühlfläche und danach vorbei an der hinteren Kühlfläche. Im Inneren des hinteren Abschnittes HA ist der hintere Halbleiterkörper IC an einem wärmeleitenden hinteren, vom vorderen

– 4 –                    VPA 84 P 1584 E

verschiedenen, Befestigungselement SC, WL, FE, SO, das gut wärmeleitend mit der hinteren Kühlfläche verbunden ist, befestigt.

Das hintere Befestigungselement SC, WL, FE, SO enthält Ausführungsbeispiele von jenen Federelementen FE, WL, welche nach dem Prinzip der vorliegenden Erfindung aufgebaut sind. Dieses Prinzip der Erfindung wird also nun erläutert an dem Beispiel, wie gemäß Fig. 1 mittels Federelementen die Kühlung des hinteren Halbleiterkörpers IC verbessert wird; – auf den vorderen Halbleiterkörper D, insbesondere auf dessen Kühlung, braucht hier im Rahmen der Beschreibung der Erfindung nicht mehr weiter eingegangen zu werden.

Die Figuren zeigen also Varianten der Erfindung mit einem Gehäuse mit Gehäusewänden W, G, vgl. Fig. 1,2.5 und 6. Zumindest Teile der, z. B. ganz aus Metall bestehenden, Gehäuseoberfläche W, G werden im Betrieb durch ein fließfähiges Kühlmedium KL, bevorzugt durch Luft KL, gekühlt. Der Wärmewiderstand zwischen dem Halbleiterkörper IC und der wärmeleitend mit ihm verbundenen Kühlfläche der Gehäuseoberfläche wird dadurch besonders niedrig, daß der Freiraum zwischen dem Halbleiterkörper IC und der Gehäusewand W, G mindestens ein, sich einerseits gegen den Halbleiterkörper IC und andererseits gegen die Gehäusewand W, G stemmendes, wärmeleitendes Federelement WL, FE enthält; – daß die Wärme, vgl. Fig. 1, 2 und 5, also z.B. nicht nur über den dort gezeigten, gut wärmeleitenden Sockel SO zur Kühlfläche der Gehäusewand G, W abfließt, sondern auch über die Federelemente zur Kühlfläche der Gehäusewand. Die Figuren zeigen hierbei nicht nur ein einziges Federelement, sondern ein ganzes System von Federelementen. Zusätzlich kann das erfindungsgemäße Gehäuse nicht nur einen einzigen Halbleiterkörper IC, sondern noch weitere Halbleiterkörper und/oder sonstige elektronische Bauteile enthalten, vgl. z.B. den Kondensator KO in Fig. 1.

Die in Fig. 1 gezeigten Fiederzungen WL sind Bestandteile von zwei bandförmigen, jeweils an ihrem oberen und unteren Rand gefiederten Federelementen WB/WL, die in Fig. 2 im Schnitt gezeigt sind und von denen je eines seitlich links und rechts neben einer relativ massiven gut wärmeleitenden Wärmeverteil-Abdeckung WS zwischen den Halbleiterkörper IC und den Gehäuseseitenwänden symmetrisch zueinander eingefügt ist. Die Fiederzungen federn und drücken auf die Gehäuseseitenwände, wobei sich der ungefiederte mittlere Bereich WB dieser beiden bandförmigen Federelemente jeweils seitlich an der gut wärmeleitenden Abdeckung WS abstützt. Weil diese Federelemente WB/WL ihrerseits so aus wärmeleitendem Material geformt sind, daß sie selbst sogar gut Wärme leiten können, leiten sie im Betrieb einen Teil der Verlustwärme des Halbleiterkörpers IC an die von ihnen gedrückten Gehäuseseitenwände weiter. Wegen der dichten Fiederung drücken alle federndern Fiederzungen, die einzeln auch eine gewisse Torsionsbewegung aufweisen können, optimal großflächig gegen die Gehäuseseitenwand, so daß der Wärmewiderstand dieser gefiederten Federelemente WB/WL selbst bei großen Herstellungstoleranzen deutlich kleiner ist, als wenn diese bandförmigen Federelemente WB/WL an ihren Rändern ungefiedert wären. Zur weiteren Verbesserung des Wärmeflusses über diese Federelemente WB/WL kann zusätzlich der Wärmeübergang zwischen der Abdeckung WS und den beiden Federelementen WB/WL dadurch erleichtert werden, daß die Federelemente im Bereich WB mit der jeweils berührten Abdeckungs-Seitenfläche in besonders gut wärmeleitender Weise verbunden, z.B. verlötet angeschweißt oder angeklebt, werden, vgl. das dadurch erhaltne Halbfertig-Bauteil aus der hier U-förmigen Abdeckung WS und den angeschweißten Federelementen WB/WL in Fig. 3 mit den Ausführungen in Fig. 1 und 2. Dieses Halbfertig-Bauteil wird mit der Unterseite der Abdeckung WS, zwischen deren Außenflanken, mit dem Wärme erzeugenden Halbleiterkörper IC, z.B. durch Andruck Klebung oder Lötung, gut wärmeleitend verbunden, vgl. Fig. 1 und 2.

Da der Wärmefluß über die Unterseite des Halbleiterkörpers IC, über dessen Substrat SC, über den Sockel SO, über den Boden der Gehäusewand G, über den Luftspalt zur vom Kühlmedium KL gekühlten (Epoxi-)Leiterplatte LP wegen des hohen Wärmewiderstandes dieses Wärmeflußweges kaum bedeutend ist, fließt die über den Sockel SO abfließende Wärme weitgehend über den Gehäuseboden und über die Gehäuseseitenwände (und zwar in dieselben Seitenwände, in die über die Federelemente WB/WL ein eigener Wärmestrom direkt abfließt) weiter zur Kühlfläche auf der Gehäuseoberfläche. Die Teilaufgabe, den Wärmefluß vom Halbleiterkörper IC an diese Gehäuseseitenwände, mit besonders niedrigem Wärmewiderstand und überdies möglichst gleichmäßig auf die ganze Länge der Gehäuseseitenwände verteilt, abzuleiten, wurde also mittels der Abdeckung WS und den beiden gefiederten Federelementen WB/WL gelöst, und zwar so, daß sich kein(oft störend)hoher Federdruck auf den Halbleiterkörper IC auswirkt. Die verhältnismäßig dicke, z.B. aus Cu bestehende Wärmeverteil-Abdeckung WS nimmt wegen ihres äußerst geringen inneren Wärmewiderstandes jederzeit nahezu überall sofort gleichmäßige Temperaturen an. Von dieser Abdeckung WS aus werden die seitlichen gefiederten Federelemente WB/WL also mit Teil-Wärmeströmen gespeist, und zwar auch noch nach jahrzehntelangem Betrieb, weil an den Materialien und an den Berührungsflächen kaum je Brüche auftreten können, z.B. weil kaum je nennenswerte Scherkräfte auftreten.

Die Federzungen WL können auch unterschiedlich lang gemacht werden, womit, wegen ihrer dann oft unterschiedlichen Wärmewiderstände, auch wegen ihrer unterschiedlichen Andruckkräfte, eine noch gleichmäßigere Wärmeverteilung in den Gehäuseseitenwänden erreicht werden kann.

Die bandförmigen gefiederten Federelemente WB/WL können für sich aus Blech in einem einzigen Arbeitsgang gleichzeitig gestanzt und vorgebogen werden, also für sich ähnlich leicht wie die Abdeckung WS durch Stanzen und Biegen hergestellt werden. Bis zum Verbinden der Federelemente WB/WL mit der Abdeckung WS sind die Federzungen WL an ihren äußeren Enden bevorzugt zunächst durch Stege miteinander verbunden, um das Handling zu verbessern. Nach den Verbinden der Federelemente WB/WL mit der Abdeckung WS werden diese Stege abgeschnitten.

Zwei symmetrisch angebrachte seitliche Federelemente WB/WL, statt nur eines einzigen seitlichen Federelements WB/WL, wobei beide Federelemente WB/WL durch federnden Andruck die gegenüberliegenden Seitenwände kontaktieren, haben auch den Vorteil, daß sie an diesen Gehäuseseitenwänden gleich große Andruckkräfte erzeugen, also die Abdeckung WS im Gehäusezentrum gut zentrieren.

Besonders wenn die Abdeckung WS nicht starr am Halbleiterkörper IC befestigt ist, also z.B. nicht angeklebt wird, kann man zur Verbesserung des Wärmeüberganges vom Halbleiterkörper IC zur Abdeckung WS, besonders aber auch zur Verbesserung des Wärmeabflusses von der Abdeckung WS zur Gehäusewand - nämlich nun zum Gehäusedeckel, über der Abdeckung WS nach oben zusätzlich eine oder mehrere wärmeleitende Federelemente FE anbringen, vgl. Fig. 1, 4 und 5, die sich gegen den Gehäusedeckel W und gegen die Abdeckung WS abstützen, also die Abdeckung WS auf den Halbleiterkörper IC drücken. Diese Federelemente FE leiten also ihrerseits einen zusätzlich Teil-Wärmestrom von der Abdeckung WS direkt zum Gehäusedeckel W ab. Auch diese zusätzlichen Federelemente können bandförmige, an ihren beiden Rändern gefiederte Bleche FE darstellen, welche z.B. den in den Figuren gezeigten ovalen Querschnitt erhalten können, vgl. Fig. 1, 4 und 5.

Auch diese Federelemente können starr an de Abdeckung WS, bevorzugt vor dem Einbau der Federelemente in das Gehäuse W/G, befestigt, z.B. gelötet, verschweißt oder verklebt, werden, vgl. das entsprechende Halbfertig-Bauteil in Fig. 4.

Alle Fiederzungen der verschiedenen Federelemente FE, WB/WL können, z.B. durch ein Klebemittel, beim Einsetzen in das Gehäuse mit den jeweils betreffenden Gehäuse-wänden starr verbunden werden, insbesondere um eine besonders hohe mechanische Rüttelfestigkeit, sowie evtl. auch um eine weitere Verbesserung der Wärmeableitung zu erreichen.

Unter der Abdeckung WS können noch weitere Bauteile angeordnet werden, vgl. z.B. den Kondensator KO in Fig. 1, wobei die Abdeckung WS - und z.B. auch das Federelement FE - bei Bedarf auch, entsprechend der unterschiedlichen Bauhöhen der verschiedenen Bauteile IC/KO, durch Prägen/Pressen gezielt Unebenheiten aufweisen kann, vgl. Fig. 6.

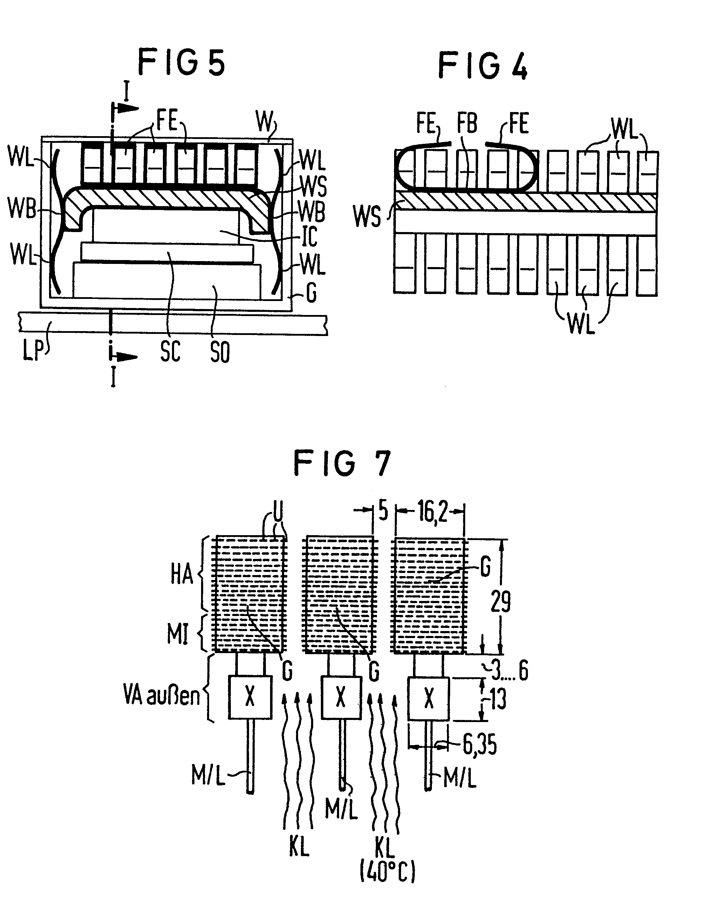

Um auch noch den Wärmeübergangswiderstand zwischen der vom Kühlmedium KL gekühlten Gehäuseoberfläche/ Kühlfläche und dem Kühlmedium KL, z.B. Kühlluft KL, zu verringern, besonders wenn zusätzlich äußerst beengte Einbauplatzverhältnisse z.B. gemäß Fig 7 (alle Längenangaben in mm-Einheiten) vorliegen,*)die Gehäuseoberfläche z.B. durch Rippen Punzen Spitzen und/oder Löcher vergrößern, vgl. die Rippen/Spitzen in Fig. 7; - also z.B. gemäß den Angaben in der prioritätsgleichen Anmeldung P .. .. ..... (VPA 84 P **1585**) vergrößern.

*) kann man zusätzlich 4 Patentansprüche, 7 Figuren

Patentansprüche.

1. Gehäuse für einen im Betrieb Verlustwäreme abgebenden Halbleiterkörper (IC), wobei    , z.B. ganz aus
Metall bestehende, Gehäuseoberflächen(W, G) im Betrieb
durch ein fließfähiges Kühlmedium (KL), bevorzugt Kühlluft (KL), gekühlt werden,und wobei der Wärmewiderstand
zwischen dem Halbleiterkörper (IC) und der wärmeleitend
mit ihm verbundenen Kühlfläche der Gehäuseoberfläche
niedrig ist,
- insbesondere Gehäuse für ein 200 MBit-Lichtsendemo-
· dul mit Treiber (IC),
d a d u r c h   g e k e n n z e i c h n e t ,   daß
- ein Freiraum zwischen dem Halbleiterkörper (IC) und
der Gehäusewand (W, G) mindestens ein sich einerseits zwischen den Halbleiterkörper (IC) und andererseits  __   die Gehäusewand (W, G) stemmendes wärmeleitendes Federelement (WL, FE) enthält.

2. Gehäuse nach Patentanspruch 1,
d a d u r c h   g e k e n n z e i c h n e t ,   daß
- mindestens eines der Federelemente (WL, FE) ein am
Rande gefiedertes Blech darstellt, dessen federnde
Fiederzungen im Betrieb Wärme leiten.

3. Gehäuse nach Patentanspruch 1 oder 2,
d a d u r c h   g e k e n n z e i c h n e t ,   daß
- zwischen dem Federelement (WL, FE) und dem Halbleiterkörper (IC) eine gut wärmeleitende Wärmeverteil-
Abdeckung (WS), bevorzugt aus dickem Metallblech, eingefügt ist.

4. Gehäuse nach Patentanspruch 2 oder 3,
d a d u r c h   g e k e n n z e i c h n e t ,   daß
- die Wärmeverteil-Abdeckung (WS) und/oder ein ungefiederter unebener Bereich des Bleches (WL) an die Form
des Halbleiterkörpers (IC) zumindest einigermaßen angepaßt ist.

5. Gehäuse nach einem der vorhergehenden Patentansprüche,
d a d u r c h   g e k e n n z e i c h n e t ,   daß
- die Federkraft von mindestens einem der Federelemente (WB/WL) zumindest teilweise sich nicht als
  mechanischer Druck auf den Halbleiterkörper (IC)
  auswirkt, sondern an ihm (IC) zumindest teilweise
  vorbeigeleitet ist (Fig. 2).

FIG 1

FIG 2

FIG 3

FIG 6

## FIG 5

I

FE        W
WL                    WL
                      WS
WB                    WB
                      IC
WL                    WL
                      G
LP        SC    SO
I

## FIG 4

FE    FB    FE        WL
WS

WL

## FIG 7

U
|← 5 →|← 16,2 →|
HA                          G
MI                          29
VA außen    G         G    ~3....6
            X    X    X    13
                          |← 6,35
M/L        M/L       M/L
      KL        KL
           (40°C)

**Europäisches Patentamt**

## EUROPÄISCHER RECHERCHENBERICHT

EP 85 10 9825

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 020 911 (IBM)<br>* Figuren 1-3,5; Patentansprüche 1-3; Zusammenfassung * | 1 | H 01 L 23/46<br>H 01 L 23/42<br>H 01 L 25/16 |
| A | | 2 | |
| | --- | | |
| Y | DE-A-3 129 996 (SIEMENS)<br>* Zusammenfassung * | 1 | |
| | --- | | |
| A | EP-A-0 088 246 (IBM)<br>* Figuren 1,2 * | 1,2 | |
| | --- | | |
| A | IBM TECHNICAL DISCLOSURE BULLETIN, Band 20, Nr. 12, Mai 1978, Seite 5203, New York, US;<br>H. ECKENBACH et al.:<br>"Semiconductor module with heat transfer"<br>* Figuren 2,3 * | 1,2 | |
| | | | RECHERCHIERTE SACHGEBIETE (Int. Cl.4) |
| | ----- | | H 01 L |

Der vorliegende Recherchenbericht wurde für alle Patentansprüche erstellt.

| Recherchenort<br>DEN HAAG | Abschlußdatum der Recherche<br>23-10-1985 | Prüfer<br>DE RAEVE R.A.L. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82